# EUROPEAN PATENT SPECIFICATION

(11) **EP 3 243 655 B1**
(45) Date of publication and mention of the grant of the patent: **24.04.2019**
(21) Application number: 16772161.2
(22) Date of filing: 10.03.2016
(51) Int. Cl.: B32B 27/20, B32B 27/32, G02B 1/14, G02B 1/16, G02B 5/30, B32B 17/10

(54) **LIGHT-TRANSMITTING LAMINATE FOR OPTICAL APPLICATIONS**
LICHTDURCHLÄSSIGES LAMINAT FÜR OPTISCHE ANWENDUNGEN
STRATIFIÉ TRANSMETTANT LA LUMIÈRE POUR APPLICATIONS OPTIQUES

(30) Priority: 31.03.2015 JP 2015071735
(43) Date of publication of application: 15.11.2017
(73) Proprietor: Sumitomo Riko Company Limited, Komaki-shi, Aichi 485-8550 (JP)
(72) Inventor: INUDUKA, Masataka, Komaki-shi, Aichi 485-8550 (JP); IKENO, Shoichi, Komaki-shi, Aichi 485-8550 (JP); TAKAO, Yuzo, Komaki-shi, Aichi 485-8550 (JP); YAMAZAKI, Yuichiro, Komaki-shi, Aichi 485-8550 (JP); GOTO, Osamu, Komaki-shi, Aichi 485-8550 (JP); NARASAKI, Tetsuji, Komaki-shi, Aichi 485-8550 (JP)
(74) Representative: Müller-Boré & Partner Patentanwälte PartG mbB
(86) International application number: PCT/JP2016/057485
(87) International publication number: WO 2016/158277

(56) References cited:
- EP-A1- 2 472 295
- EP-A1- 2 535 180
- WO-A1-2014/208745
- WO-A1-2014/208745
- JP-A- H0 331 344
- JP-A- 2004 175 884
- JP-A- 2010 023 234
- US-A1- 2008 102 262

## Description

The present application relates to a light-transmitting laminate for optical use and more particularly relates to a light-transmitting laminate for optical use that is excellent in thermal insulation property and electrical conductivity.

Conventionally, a light-transmitting lamination film is attached to a window glass of the architecture such as a building and a house or a vehicle such as an automobile in order to shield solar radiation. A polypropylene film, which is low in infrared absorption, is used as abase film of the light-transmitting lamination film.
Patent Literature 1: JP 62-54955
Patent Literature 2: WO 2014/208745
EP 2 535 180 A1 describes a method for producing a heat-shielding ply structure, a heat-shielding ply-structure, and a transparent laminate film for a ply structure. EP 2 472 295 A1 describes a transparent laminate film and a method for producing the same.

A plastic film made of polyolefin such as polypropylene has poor adhesion to a metal layer or a metal oxide layer acting as a thermal insulation layer. Further, the plastic film is soft and has unsmooth surfaces, and thus has a low workability since wrinkles easily occur when it is treated.

An object of the present disclosure is to provide a light-transmitting laminate for optical use that is excellent in adhesion and workability.

In order to solve the problem, a light-transmitting laminate for optical use according to the present invention contains a polyolefin layer; a thin film layer containing a metal layer or a metal oxide layer; and a surface protection layer, as an outermost layer, in contact with the polyolefin layer that protects a surface of the polyolef in layer, the metal layer made of at least one selected from silver, a silver alloy, aluminum, an aluminum alloy, iron, and an iron alloy, the metal oxide layer made of at least one selected from an indium tin oxide, an indium zinc oxide, a zinc oxide, a tin oxide, an aluminum zinc oxide, a gallium zinc oxide, and an indium gallium zinc oxide, the thin film layer formed by sputtering, the surface protection layer comprising an organic-inorganic hybrid material, and the polyolefin layer containing on both surfaces thereof silica particles, wherein silica particles have a maximum particle diameter within a range of 6 to 11 µm, and wherein the polyolefin layer contains the silica particles on the surface thereof at a content of 10 to 40 particles/100 *µ*m².

It is preferable that the metal layer is made of silver or the silver alloy. It is preferable that the polyolefin layer contains a biaxially oriented polypropylene film. It is preferable that the silica particles are spherical particles. According to the present invention, the silica particles have a maximum particle diameter within a range of 6 to 11 µm. According to the present invention, the polyolefin layer contains the silica particles on the surface thereof at a content of 10 to 40 particles/100 *µ*m². Further, according to the present invention, the laminate contains, as an outermost layer, a surface protection layer in contact with the polyolefin layer that protects the surface of the polyolef in layer, the surface protection layer containing an organic-inorganic hybrid material. It is preferable that the organic-inorganic hybrid material contains 2.1 to 5.2 mass% of a metal ingredient . It is preferable that the polyolefin layer has a haze of 3.0% or less. It is preferable that the thin film layer contains the metal layer, and further contains an organic thin film that has a higher refractive index than the metal layer. It is preferable that the organic thin film is made of a polymer having a triazine ring.

The light-transmitting laminate for optical use according to the preferred embodiment of the present invention contains the polyolefin layer having on the both surfaces thereof the silica particles, whereby the polyolefin layer has smooth surfaces, hard to be wrinkled when treated, and has an excellent workability. Further, excellent adhesion is achieved between the polyolefin layer and the metal layer or the metal oxide layer.

When the metal layer is made of silver or the silver alloy, the metal layer exhibits excellence in light transmitting property, solar-radiation shielding property, heat-ray reflectivity, and electrical conductivity. When the polyolefin layer contains the biaxially oriented polypropylene film, the layer exhibits excellence in light transmitting property, endurance, and workability. When the silica particles are the spherical particles, haze caused by the particles is low, and thus deterioration of the laminate in appearance is suppressed. When the silica particles have the maximum particle diameter of 6 µm or larger, the polyolefin layer has excellent workability. When the silica particles have the maximum particle diameter of 11 µm or smaller, haze caused by the particles is low, and thus deterioration of the laminate in appearance is suppressed. When the polyolefin layer contains the silica particles on the surface thereof at the content of 10 particles/100 *µ*m² or more, the polyolefin layer has excellent workability. When the polyolefin layer contains the silica particles on the surface thereof at the content of 40 particles/100 *µ*m² or less, haze caused by the particles is low, and thus deterioration of the laminate in appearance is suppressed.

Further, when the light-transmitting laminate for optical use contains, as an outermost layer, a surface protection layer in contact with the polyolefin layer that protects the surface of the polyolefin layer, the polyolefin layer exhibits superior resistance to external damage. When the surface protection layer contains the organic-inorganic hybrid material, a curing shrinkage of the surface protection layer is small, and thus excellent adhesion is achieved between the protection and polyolefin layers. When the organic-inorganic hybrid material contains 2.1 mass% or more of a metal ingredient, more excellent adhesion is achieved between the protection and polyolefin layers. When the organic-inorganic hybrid material contains 5.2 mass% or less of a metal ingredient, increase of a thermal transmittance of the surface protection layer is prevented, and thus the protection layer exhibits an excellent heat insulation property. When the polyolefin layer has the haze of 3.0% or less, haze caused by the particles is low, and thus deterioration of the laminate in appearance is suppressed. When the thin film layer contains the metal layer, and further contains an organic thin film that has a high refractive index than the metal layer, the light-transmitting laminate for optical use exhibits an excellent light transmitting property. When the organic thin film is made of a polymer having a triazine ring, refractive index of the organic thin film is high, and thus the light-transmitting laminate for optical use exhibits an excellent light transmitting property.
Figure 1 is a cross-sectional view showing a light-transmitting laminate for optical use according to a preferred embodiment of the present invention.
Figure 2A is an enlarged cross-sectional view of a polyolefin layer in which spherical silica particles are on the surfaces of the layer.
Figure 2B is an enlarged cross-sectional view of a polyolef in layer in which needle - shaped silica particles are on the surfaces of the layer.
Figure 3 is a partially enlarged cross-sectional view showing the light-transmitting laminate for optical use according to the preferred embodiment of the present invention.
Figure 4 is a cross-sectional view showing a light-transmitting laminate for optical use according to another preferred embodiment of the present invention.

A detailed description of a light-transmitting laminate for optical use according to a preferred embodiment of the present invention will now be provided.

A light-transmitting laminate for optical use according to a preferred embodiment of the present invention contains a polyolefin layer, a thin film layer that is a metal layer or a metal oxide layer, and a surface protection layer, as an outermost layer, in contact with the polyolefin layer that protects a surface of the polyolefin layer.

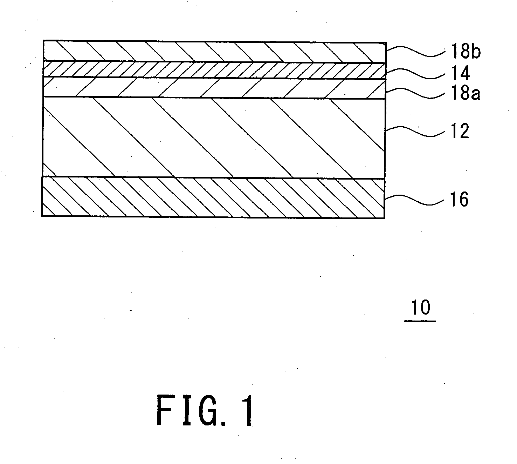

Figure 1 shows the light-transmitting laminate for optical use according to the preferred embodiment of the present invention. As illustrated in Fig. 1, the light-transmitting laminate for optical use 10 includes a polyolefin layer 12, a thin film layer 14, and a surface protection layer 16. The thin film layer 14 is a metal layer. High-refractive-index layers 18a, 18b which have higher refractive index than the thin film layer 14 (i.e., metal layer) are placed on the both surfaces of the thin film layer 14. One of the high-refractive-index layers 18a,18b (i.e., 18a layer) is placed on one surface of the polyolefin layer 12, in contact with the surface of the polyolefin layer 12. The surface protection layer 16 is placed on the other surface of the polyolefin layer 12, in contact with the surface of the polyolefin layer 12. The surface protection layer 16, protecting the surface of the polyolefin layer 12, is placed as the outermost layer of the light-transmitting laminate for optical use 10. An adhesion layer may be further placed on the surface of the thin film layer 14. The light-transmitting laminate for optical use 10 may be attached to an adherend such as a window and a display via the adhesion layer. The surface of the adhesion layer may be covered with a separator, as necessary.

In the light-transmitting laminate for optical use 10, the polyolefin layer 12 may consist of a polyolefin film. The polyolefin film is in the form of a membrane, and has a thickness of 200 *µ*m or smaller, or 250*µ*m or smaller. The film may have a thickness of 200 µm or larger, or 250*µ*m or larger, if keeping sufficient flexibility to be rolled. The film is generally supplied in the form of a roll.

The polyolefin film has a light transmitting property. Here, a light transmitting property means that a transmittance is 50% or higher with respect to light within a wavelength range of 360 to 830 nm. Examples of the polyolefin constituting the polyolefin film include linear and cyclic polyolefins. Examples of the linear polyolefin include polyethylene, polypropylene, ethylene-alpha-olefin copolymer. Examples of the cyclic polyolefin include cycloolefin polymer. From the viewpoints of a light transmitting property, endurance, and workability, the polyolefin is preferably polypropylene. Especially, from the view point of the light transmitting property, the polypropylene is preferably biaxially oriented polypropylene (OPP).

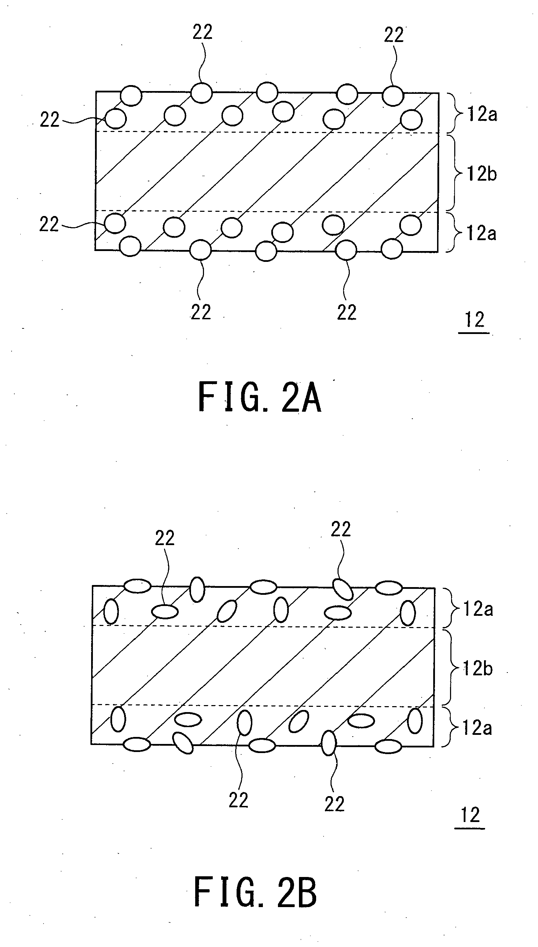

As illustrated in Figure 2, the polyolefin layer 12 contains on the both surfaces silica particles 22. The polyolefin film constituting the polyolefin layer 12 is soft and has unsmooth surfaces, and thus the polyolefin layer 12 has low workability because wrinkles easily occur when treated. The silica particles 22 on the both surfaces of the polyolefin layer 12 allow the layer 12 to obtain smooth surfaces, to be hardly wrinkled when treated, and to obtain an excellent workability. Further excellent adhesion is achieved between the polyolefin layer 12 and the metal layer or the metal oxide layer. Silica has a refractive index close to that of polyolefin, and thus reflection of light at the interface between the silica and the polyolefin is small. By containing silica in the form of particles 22, the polyolefin layer 12 improves surface smoothness with maintaining an optical property.

The silica particles 22 are employed for improving surface smoothness and adhesion to other layers of the polyolefin layer 12. Accordingly, it is enough that the silica particles 22 are present on the both surfaces of the polyolefin layer 12. The silica particles 22 may be present or absent in the interior portion of the polyolefin layer 12. However, the light-transmitting laminate for optical use 10 preferably has a desired appearance since clear vision through the laminate is important in view of its optical use. Accordingly, from the viewpoint of inhibiting the polyolef in layer 12 from being deteriorated in haze property and further in appearance, it is preferable that the silica particles 22 are absent in the interior portion of the polyolefin layer 12 or smaller amounts of the silica particles 22 are present in the interior of the layer 12 than on the surface thereof.

In the polyolefin layer 12, a clear boundary may be present or absent between the surface portions in which the silica particles 22 are present and the interior portion in which the silica particles 22 are absent or smaller amounts of the particles 22 are present. For instance, as illustrated in Fig. 2, a clear boundary may be present between surface layers 12a in which the silica particles 22 are present and an inner layer 12b constituting the interior portion of the polyolefin layer 12. Such a layer structure may be obtained by application of a polyolefin paint containing the silica particles 22 on the surfaces of a polyolefin film not containing the silica particles 22, and then drying of the film covered with the paint, for instance.

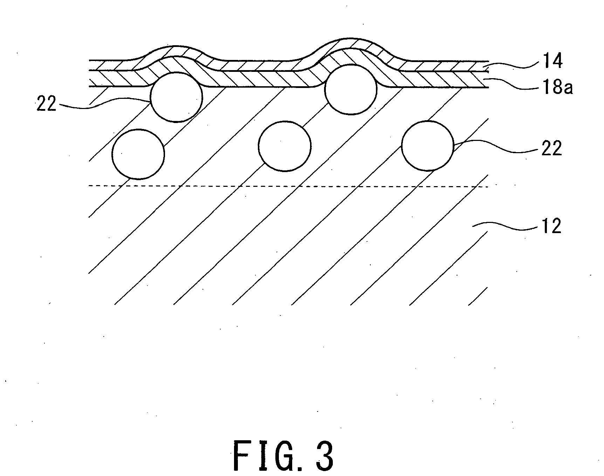

In the polyolefin layer 12, the silica particles 22 are preferably spherical particles as illustrated in Fig. 2A, although they may be needle-shaped particles as illustrated in Fig. 2B. Each of the spherical particles is a particle that has a relatively small difference between its maximum diameter (long diameter) and minimum diameter (short diameter), and the ratio (i.e., aspect ratio) between the maximum and minimum diameters is 1.1 or lower, for instance. Meanwhile, the needle-shaped particles are particles whose aspect ratio is above 1.1 or 2.0 or higher. When the silica particles 22 are spherical particles, deterioration of the laminate 10 in appearance due to lowering of haze caused by the particles 22 is more effectively suppressed compared with the case where the silica particles 22 are needle-shaped particles. This is presumably because the spherical particles have smaller specific surface areas. As mentioned above, silica has a refractive index close to that of polyolefin, and thus reflection of light at the interface between the silica and the polyolefin is small . Accordingly, diffuse reflection of light on the surface of the polyolefin layer 12 due to the surface roughness of the layer 12 formed by the silica particles 22 has a great influence on the haze of the layer 12. Further, as illustrated in Figure 3, the thin film layer 14 placed on the polyolefin layer 12 is formed by sputtering to have a small thickness in the order of nanometers. Therefore, the surface roughness of the polyolefin layer 12 formed by the silica particles 22 has a great effect on the surface state of the thin film layer 14. Thus, diffuse reflection of light on the surface of the thin film layer 14 effected by the surface roughness of the polyolefin layer 12 formed by the silica particles 22, also has a great influence on the haze of the polyolefin layer 12.

The shape of the silica particles 22 may be defined with respect to particles having a predetermined particle diameter or larger, which have a high effect on the polyolefin layer 12. For instance, the shape of the silica particles 22 may be determined with respect to particles 22 whose particle diameter is 0.5 µm or larger.

From the viewpoints of improving surface smoothness, preventing wrinkling under treatment, and improving workability of the polyolefin layer 12, the particle diameter of the silica particle 22 is 6 µm or larger. From the viewpoint of inhibiting the polyolefin layer 12 from being deteriorated in haze property and further in appearance, the particle diameter of the silica particle 22 is 11 µm or smaller, and even more preferably 9 µm or smaller. The particle diameter of the silica particles 22 is estimated based on the maximum particle diameter. The maximum particle diameter is a diameter of the largest particle among the particles observed within a predetermined observation area. As for both spherical and needle-shaped particles, the maximum particle diameter is the maximum diameter (long diameter) of a particle.

From the viewpoints of improving surface smoothness, preventing wrinkles under treatment, and improving workability of the polyolefin layer 12, the content of the silica particles 22 contained in the surfaces of the polyolefin layer 12 is 10 particles/100 *µ*m² or higher, and more preferably 15 particles/100 *µ*m² or higher. From the viewpoint of inhibiting the polyolefin layer 12 from being deteriorated in haze property and further in appearance, the content of the silica particles 22 contained in the surfaces of the polyolefin layer 12 is 40 particles/100 *µ*m² or lower. The content of the silica particles 22 may be estimated by counting the number of the silica particles 22 observed on the surfaces of the polyolefin layer 12. The content of the silica particle 22 may be estimated by counting the silica particles 22 having a predetermined particle diameter or larger, which have a high effect on the polyolefin layer in smoothness and haze property. For instance, the content of the silica particles 22 may be obtained by counting the silica particles 22 whose particle diameter is 0.5 *µ*m or larger.

The shape, particle diameter, and content of the silica particles 22 may be examined by observation of the surfaces and the cross section in the thickness direction of the polyolefin layer 12 with the use of a laser microscope. As the laser microscope, "OLYMPUS LEXT OLS 4000" may be used. The observation is conducted with respect to arbitrary selected 15 observation areas of 242.3 *µ*m² on the surfaces of the polyolefin layer 12. The maximum particle diameter is defined by a diameter of the largest particle among the particles observed in the 15 observation areas . The content of the silica particles 22 is defined by the lowest and highest contents of the silica particles 22 among the contents observed in the 15 observation areas.

The haze of the polyolefin layer 12 is preferably 3.0% or lower, more preferably 2.0% or lower, even more preferably 1.0% or lower, and most preferably 0.8% or lower. The haze property of the polyolefin layer 12 is lowered by employing the silica particles 22. Still, it is preferred to use a relatively smooth polyolefin film for eliminating other factors than the silica particles 22 that may have an effect on the haze of the polyolefin layer 12. To this end, it is preferable that a structure such as a groove is not artificially formed on the surfaces of the polyolefin layer 12.

A surface treatment may be applied on either or both surfaces of the polyolefin layer 12, from the view point of improving adhesion to the high-refractive-index layer 18a and the surface protection layer 16 both in contact with the layer 12. Examples of the surface treatment include corona and plasma treatments. When the surface treatment is applied, hydroxyl and oxygen groups are formed on the surface of the polyolefin layer 12, and thus adhesion of the polyolefin layer 12 is improved.

The metal layer is made of a metal that effectively reflects far-infrared rays, and may act as a solar radiation layer. The metal layer may be formed by sputtering. The high-refractive-index layers 18a, 18b improve a light transmitting property of the laminate 10 when laminated together with the metal layer. The high-refractive-index layers 18a,18b have higher refractive index than the metal layer . A refractive index is defined with respect to light having a wavelength of 633 nm. Examples of the high-refractive-index layers 18a, 18b include an organic thin film, and a metal oxide thin film. The refractive index of the high-refractive-index layers 18a,18b is preferably 1.7 or higher.

Examples of the metal constituting the metal layer include silver, a silver alloy, aluminum, an aluminum alloy, iron, and an iron alloy. The metals may be contained in the metal layer singly or in combination. Among them, from the viewpoint of excellence in light transmitting property, solar-radiation shielding property, heat ray reflectivity, and electrical conductivity when laminated, the metal is preferably silver or the silver alloy. From the viewpoint of improving durability with respect to environmental factors such as heat, light, and moisture, the metal is more preferably the silver alloy containing silver, as a main ingredient, and at least one metal element such as copper, bismuth, gold, palladium, platinum, and titanium. It is even more preferable that the metal is a copper-containing silver alloy (Ag-Cu alloy), a bismuth-containing silver alloy (Ag-Bi alloy), or a titanium-containing silver alloy (Ag-Ti alloy).

From the viewpoints of stability and a solar-radiation shielding property, the metal layer preferably has a thickness of 3 nm or larger, more preferably 5 nm or larger, and even more preferably 7 nm or larger. From the viewpoints of a light transmitting property and economic performance, the metal layer preferably has a thickness of 30 nm or smaller, more preferably 20 nm or smaller, and even more preferably 15 nm or smaller.

The organic thin film constituting the high-refractive-index layers 18a,18b is made of an organic polymer. In view of excellence in adhesion, the organic polymer preferably contains functional groups containing at least one element selected from N, S, and O, each making a strong bond with a metal of the metal layer. The functional group containing at least one of these elements allows the polymer constituting the organic layer to be surely adhered to the metal layer in contact with the organic layer, accomplishing excellent adhesion between the organic and metal layers. Among N, S, and O elements, N and S elements specially make strong bonds with Ag. Accordingly, when the organic thin film is made of a polymer including a functional group containing N or S element, more excellent adhesion is achieved between the organic thin film and the metal layer containing Ag. A polymer containing N or S element has a tendency to have a relatively high refractive index, and thus such polymer is preferable.

Examples of the functional group containing N element include carbazole, imide and nitrile groups. Among them, from the viewpoint of excellent adhesion to the metal layer, the carbazole and imide groups are more preferable. Examples of the polymer including a functional group containing N element include polyvinyl carbazole (PVK), polyimide, and a polymer including a triazine ring. The polymer including a triazine ring is especially preferable, from the viewpoint of having a high refractive index (1.70 or higher) due to its constitution.

Examples of the functional group containing S element include sulphonyl (-SO₂-), thiol, and thioester groups. Among them, from the viewpoint of excellent adhesion to the metal layer, the sulphonyl and thiol groups are more preferable. Examples of the polymer including a functional group containing S element include polyethersulfone (PES), polysulfone, and polyphenyl sulfone.

Examples of the functional group containing O element include carboxyl, ester, ketone, and hydroxyl groups. Among them, from the viewpoint of excellent adhesion to the metal layer, the carboxyl and ester groups are more preferable. Examples of the polymer including a functional group containing O element include an epoxy resin.

The thickness of the organic thin film may be adjusted by considering the solar-radiation shielding property, visibility, and reflected color of the layer. From the viewpoint of easily preventing the reflected color from being reddish or yellowish and easily improving a light transmitting property, the thickness of the organic layer is preferably 10 nm or larger, more preferably 15 nm or larger, and even more preferably 20 nm or larger. From the viewpoint of easily preventing the reflected color from being greenish and easily improving a light transmitting property, the thickness of the organic layer is preferably 90 nm or smaller, more preferably 85 nm or smaller, and even more preferably 80 nm or smaller.

The organic thin film may be formed by preparing a coating liquid containing an organic polymer, applying the coating liquid to a layer, and drying the coated layer, to thereby obtain a coated layer. A solvent in which an organic polymer is dissolved may be used in preparing the coating liquid, as necessary. Examples of the solvent include alcohols such as methanol, ethanol, propanol, butanol, heptanol, and isopropyl alcohol; organic acid esters such as ethyl acetate; ketones such as acetonitrile, acetone, and methyl ethyl ketone; cyclo-ethers such as tetrahydrofuran and dioxane; acid amides such as formamide and N,N-dimethylformamide; hydrocarbons such as hexane; and aromatics such as toluene and xylene. One of these solvents may be used singly or two or more may be mixed.

When the organic layer is formed by coating, it is preferable that the polyolef in layer 12 does not include an organic acid. If the polyolefin layer 12 includes an organic acid, a coating liquid is repelled on the layer 12 and difficulty arises in forming the organic layer on the polyolefin layer 12 by coating. Examples of the organic acid include fatty and aromatic carboxylic acids . The fatty acid may be included in the polyolefin film as an anti-static agent.

A metal oxide layer constituting the high-refractive-index layers 18a,18b may be formed by sputtering. For this, the metal oxide layer may be formed as a metal oxide layer from the beginning, or formed by preparing a metal layer and oxidizing it later. Examples of the metal oxide constituting the metal oxide layer include oxides of titanium, zinc, indium, tin, indium-tin, magnesium, aluminum, zirconium, niobium, and cerium. These metal oxides may be contained in the metal oxide layer singly or in combination. Further, a composite oxide in which two or more of these metal oxides are composed together may also be applicable. In particular, from the viewpoint of having a relatively high refractive index, examples of preferable metal oxides include oxides of titanium, indium-tin, zinc, and tin.

The thickness of the metal oxide layer may be adjusted by considering the solar-radiation shielding property, visibility, and reflected color of the layer. From the viewpoint of easily preventing the reflected color from being reddish or yellowish and easily obtaining a light transmitting property, the thickness of the metal oxide layer is preferably 10 nm or larger, more preferably 15 nm or larger, and even more preferably 20 nm or larger. From the viewpoint of easily preventing the reflected color from being greenish and easily obtaining a light transmitting property, the thickness of the metal oxide layer is preferably 90 nm or smaller, more preferably 85 nm or smaller, and even more preferably 80 nm or smaller.

When the metal oxide layer constitutes the high-refractive-index layers 18a,18b, a barrier layer is preferably formed on either surface of the metal layer. The barrier layer inhibits diffusion of elements constituting the metal layer into the metal oxide layer. Further, when the organic layer constitutes the high-refractive-index layers 18a,18b, a barrier layer is preferably formed on either surface of the metal layer, from the viewpoint of preventing corrosion and oxidation degradation of the metal layer . The barrier layer is made of a metal or a metal oxide.

Specific examples of the metal constituting the barrier layer include Si, Ti, Zr, Al, Cr, Ni, and Fe. Specific examples of the metal oxide constituting the barrier layer include oxides of titanium, zinc, indium, tin, indium-tin, magnesium, aluminum, zirconium, niobium, and cerium.

From the viewpoint of easily obtaining a barrier property, the thickness of the barrier layer is preferably 1 nm or larger, more preferably 1.5 nm or larger, and even more preferably 2 nm or larger. From the viewpoint of economic performance, the thickness of the barrier layer is preferably 15 nm or smaller, more preferably 10 nm or smaller, and even more preferably 8 nm or smaller .

The barrier layer may be formed as a metal oxide layer from the beginning, or formed by preparing a metal layer and oxidizing it later. Examples of the post-oxidation include heat, pressure, chemical, and natural treatments.

From the viewpoint of achieving a high density and relatively easily controlling the thickness, the metal layer, the metal oxide layer constituting the high-refractive-index films 18a,18b, and the metal oxide layer constituting the barrier layer may be formed by sputtering. Since the layers are formed by sputtering and are in the form of thin films in the order of nanometers , the layers are shaped to follow the surface roughness of the polyolefin layer 12 formed by the silica particles 22. Accordingly, as illustrated in Fig. 3, roughness appears on the layers placed above the polyolefin layer 12 following the surface roughness of the polyolefin layer 12 formed by the silica particles 22. The roughness of the layers causes light dispersion on the surface of the layers, and thus the laminate 10 is deteriorated in a haze property. Therefore, the shape, particle diameter, and content of the silica particles 22 are preferably adjusted with considering formation of the layers by sputtering.

The surface protection layer 16 is placed as the outermost layer, and prevents the surface of the polyolefin layer 12 from being scratched, for instance. The surface protection layer 16 is made of a material containing a curable resin. Examples of the curable resin include silicone and acrylic resins. The silicone and acrylic resins may have heat, light, or aqueous curability. Examples of the acrylic resin include acrylic urethane, silicone acrylic, and acrylic melamine resins.

The surface protection layer 16 comprises an organic-inorganic hybrid material. The organic-inorganic hybrid material is made of an organic material (organic component) and an inorganic material (inorganic component) combined in nanometer or molecular level. For instance, the organic-inorganic hybrid material has a network crosslinked structure in which the inorganic material is highly dispersed in the organic material via chemical bonds . This structure maybe formed by dispersion of the inorganic material in the organic material and reaction such as polymerization between the inorganic and organic materials.

When the surface protection layer 16 is made of the organic-inorganic hybrid material, adhesion of the layer 16 is improved. This is presumably because that the inorganic component added in the material forming the surface protection layer 16 suppresses the curing shrinkage of the protection layer 16. That is to say, it is presumed that distortion of the surface protection layer 16 is decreased due to suppression of the curing shrinkage, and the stress causing a peering between the polyolefin layer 12 and the surface protection layer 16 is decreased.

Further, the curing shrinkage of the surface protection layer 16 has an influence on distortion of the layer 16, and further on adhesion between the polyolef in layer 12 and the metal layer. When the surface protection layer 16 is made of the organic-inorganic hybrid material, excellent adhesion is achieved between the polyolefin layer 12 and the metal layer without deterioration.

An example of the organic component constituting the organic-inorganic hybrid material is a curable resin. Examples of the curable resin include acrylic, epoxy, and urethane resins. The resins may be used singly or in combination. An example of the inorganic component includes a metal compound. Examples of the metal compound include Si, Ti, and Zr compounds. One kind of these compounds may be used singly or two or more kinds may be mixed in combination. Among these, from the viewpoints of scratch resistance, abrasion resistance, and versatility, the Si compound is more preferable. The metal compound is a compound that contains an inorganic component such as Si, Ti, and Zr, and that may be combined with the organic component through a reaction with the organic component such as polymerization. Specific examples of the metal compound include an organometallic compound. More specific examples of the organometallic compound include silane coupling agents, metal alkoxides, metal acylates, metal chelates, and silazane.

The ratio of the inorganic component in the organic-inorganic hybrid material is preferably 5.0 mass% or higher, and more preferably 5.5 mass% or higher. When the ratio of the inorganic component is 5.0 mass% or higher, adhesion is remarkably improved between the polyolefin layer 12 and the surface protection layer 16. When the ratio of the inorganic component is 5.5 mass% or higher, adhesion is especially improved between the polyolefin layer 12 and the surface protection layer 16. The adhesion between the polyolefin layer 12 and the surface protection layer 16 may be evaluated by a cross-cut adhesion test in accordance with JIS K5600-5-6.

The ratio of the inorganic component in the organic-inorganic hybrid material is preferably 12.3 mass% or lower, and more preferably 10.0 mass% or lower. When the ratio of the inorganic component is 12.3 mass% or lower, the coating liquid is excellent in stability, and absorption of far-infrared ray is reduced in the surface protection layer 16. When the ratio of the inorganic component is 10.0 mass% or lower, the stability of the coating liquid and the reduction of absorption of far-infrared ray are further enhanced.

The metal ratio in the surface protection layer 16 made of the organic-inorganic hybrid material is preferably 2.1 mass% or higher, and more preferably 2.3 mass% or higher. When the metal ratio is 2.1 mass% or higher, adhesion is remarkably improved between the polyolefin layer 12 and the surface protection layer 16. The metal ratio in the surface protection layer 16 made of the organic-inorganic hybrid material is preferably 5.2 mass% or lower, and more preferably 4.2 mass% or lower. When the metal ratio is 5.2 mass% or lower, the coating liquid is excellent in stability, and absorption of far-infrared ray in the surface protection layer 16 is reduced, whereby deterioration of the thermal insulation property (thermal transmittance) of the surface protection layer 16 is prevented.

The metal contained in a thickness region of 1 *µ*m of the surface protection layer 16 made of the organic-inorganic hybrid material may be examined by measuring a metal signal intensity (unit: kcps) using an X-ray fluorescence elementary analysis (XRF) (Rigaku Supermini 200) in a measurement area of ϕ30 mm.

For instance, when the metal component is Si, the signal intensity of Si in the surface protection layer 16 made of the organic-inorganic hybrid material is preferably 0.98 kcps or higher, and more preferably 1.07 kcps or higher. When the signal intensity of Si is 0.98 kcps or higher, adhesion is remarkably improved between the polyolefin layer 12 and the surface protection layer 16. The signal intensity of Si in the surface protection layer 16 made of the organic-inorganic hybrid material is preferably 2.44 kcps or lower, and more preferably 1.96 kcps or lower. When the signal intensity of Si is 2.44 kcps or lower, the coating liquid is excellent in stability, and absorption of far-infrared rays in the surface protection layer 16 is reduced, whereby deterioration of the thermal insulation property (thermal transmittance) of the surface protection layer 16 is prevented.

From the viewpoint of excellence in thermal insulation property (minimizing thermal transmittance), the thickness of the surface protection layer 16 is preferably 2.0 µm or smaller, more preferably 1.6 µm or smaller, and even more preferably 1.0 µm or smaller. From the viewpoint of excellence in scratch resistance, the thickness of the surface protection layer 16 is preferably 0.4 µm or larger, more preferably 0.6 µm or larger, and even more preferably 0.8 µm or larger.

As illustrated in Fig. 1, the light-transmitting laminate for optical use 10 may include a single metal layer, and high-refractive-index layers 18a,18b placed on the both surfaces of the metal layer to have a three-layer structure. However, any formation may be applicable to laminate the metal layer and high-refractive-index layers 18a,18b. Two or more layers may be laminated in the order of a metal layer/a high refractive index layer/a metal layer/a high refractive index layer..., from the side facing the polyolef in layer 12. Two or more layers may be laminated in the order of a high refractive index layer/a metal layer/ a high refractive index layer/ a metal layer/ a high refractive index layer..., from the side facing the polyolefin layer 12.

The light-transmitting laminate for optical use 10 may be suitably used as a light-transmitting lamination film attached to a window glass of the architecture such as a building and a house or a vehicle such as an automobile in order to shield solar radiation. Further, the light-transmitting laminate for optical use 10 may be suitably used as a transparent conductive film.

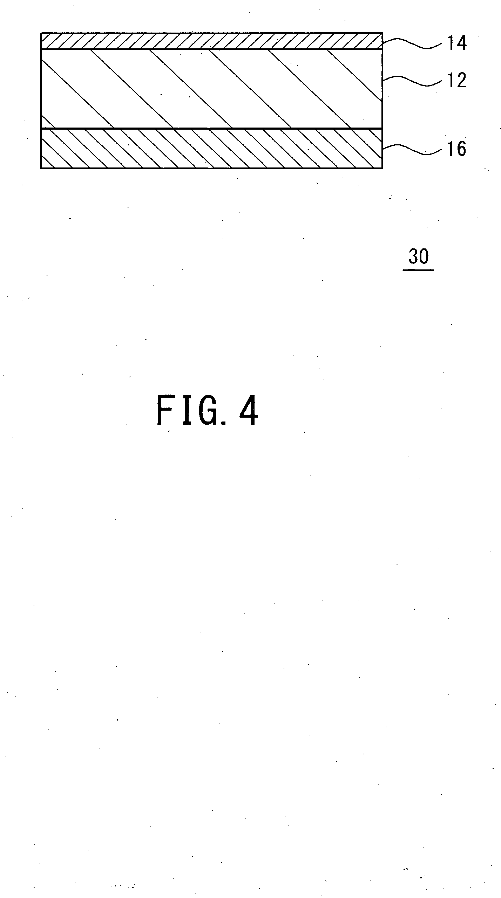

A description of a light-transmitting laminate for optical use according to another preferred embodiment of the present invention will next be provided. Figure 4 shows a light-transmitting laminate for optical use according to another preferred embodiment of the present invention.

As illustrated in Fig. 4, the light-transmitting laminate for optical use 30 contains the polyolefin layer 12, the thin film layer 14, and the surface protection layer 16. The thin film layer 14 contains a metal layer or a metal oxide layer. The thin film layer 14 is placed on one surface of the polyolefin layer 12 in contact with the surface of the polyolefin layer 12. The surface protection layer 16 is placed on the other surface of the polyolefin layer 12 in contact with the other surface of the polyolefin layer 12. The surface protection layer 16, protecting the surface of the polyolefin layer 12, is placed as the outermost layer of the light-transmitting laminate for optical use 30. An adhesion layer may be further placed on the surface of the thin film layer 14 on one side of the polyolefin layer 12. The adhesion layer allows the light-transmitting laminate for optical use 30 to be attached to a window. The surface of the adhesion layer may be covered with a separator, as necessary.

The polyolefin layer 12 and the surface protection layer 16 of the light-transmitting laminate for optical use 30 are the same in structure as the respective ones of the light-transmitting laminate for optical use 10 according to the above-described preferred embodiment of the present invention. So, the detailed description of the layers 12 and 16 of the light-transmitting laminate for optical use 30 is omitted.

When the thin film layer 14 consists of the metal layer, the light-transmitting laminate for optical use 30 obtains a light insulation property and electrical conductivity. When the thin film layer 14 consists of the metal oxide layer, the light-transmitting laminate for optical use 30 obtains electrical conductivity. Examples of the metal contained in the metal layer include silver, a silver alloy, aluminum, an aluminum alloy, iron, and an iron alloy. The metals may be contained in the metal layer singly or in combination. Examples of the metal contained in the metal oxide layer include indium tin oxide (ITO), indium zinc oxide (IZO), zinc oxide (ZnO), tin oxide (SnO₂), aluminum zinc oxide (AZO), gallium zinc oxide (GZO), and indium gallium zinc oxide (IGZO) . These species may be contained in the metal oxide layer singly or in combination.

Among them, from the viewpoints of excellence in light transmitting property, solar-radiation shielding property, and electrical conductivity, the metal is preferably silver and the silver alloy. From the viewpoint of improving durability with respect to an environmental factor such as heat, light, and moisture, the metal is more preferably a silver alloy containing silver, as a main component, and at least one or more metal elements such as copper, bismuth, gold, palladium, platinum, and titanium. It is even more preferable that the metal is a copper-containing silver alloy (Ag-Cu alloy), a bismuth-containing silver alloy (Ag-Bi alloy), or a titanium-containing silver alloy (Ag-Ti alloy).

From the viewpoints of stability, a solar-radiation shielding property, and electrical conductivity, the metal layer and the metal oxide layer each preferably have a thickness of 3 nm or larger, more preferably 5 nm or larger, and even more preferably 7 nm or larger. From the viewpoints of a light transmitting property and economic performance, the metal layer and the metal oxide layer each preferably have a thickness of 30 nm or smaller, more preferably 20 nm or smaller, and even more preferably 15 nm or smaller.

A barrier layer may be formed on the surface of the metal layer. The barrier layer is formed on either or both surfaces of the metal layer. The barrier layers prevent corrosion and oxidation degradation of the metal layer, and inhibit diffusion of elements constituting the metal layer into other layers.

Specific examples of the metal constituting the barrier layer include Si, Ti, Zr, Al, Cr, Ni, and Fe. Specific examples of the metal oxide constituting the barrier layer include oxides of titanium, zinc, indium, tin, indium-tin, magnesium, aluminum, zirconium, niobium, and cerium.

From the viewpoint of easily obtaining a barrier property, the thickness of the barrier layer is preferably 1 nm or larger, more preferably 1.5 nm or larger, and even more preferably 2 nm or larger. From the viewpoint of economic performance, the thickness of the barrier layer is preferably 15 nm or smaller, more preferably 10 nm or smaller, and even more preferably 8 nm or smaller.

The light-transmitting laminate for optical use 30 may be suitably used as a light-transmitting lamination film attached to a window glass of the architecture such as a building and a house or a vehicle such as an automobile in order to shield solar radiation. Further, the light-transmitting laminate for optical use 30 may be suitably used as a transparent conductive film.

### EXAMPLE

A description of the embodiments of the present invention will now be specifically provided with reference to Examples. Examples 1 to 4 are Reference Examples, Examples 4 to 10 are examples according to the present invention.

### (Example 1 and Comparative Example 1)

A light transmitting laminate was formed by laminating an organic layer/a metal oxide layer/a metal layer/a metal oxide layer/and an organic layer in this order to have a multilayer structure. The details are as follows:

### <Preparation of Coating Liquid for Organic Layers>

Triazine-ring contaning polymer ("UR-108NT3", manufactured by NISSAN CHEMICAL INDUSTRIES, LTD.) was diluted (solvent: PGMEA) to have a viscosity suitable for coating by a gravure coater (0.1 to 3.0 mPa ▪ s). Thus, a coating liquid for organic layers was prepared.

### <Formation of Light Transmitting Laminate>

An organic layer was formed by applying the coating liquid for an organic layer to one surface of a corona treated OPP film using a micro-gravure coater, and drying the coated film. Then, a metallic Ti layer was formed on the first organic layer by sputtering with a DC magnetron sputtering equipment. Then, anAg-Cualloy layer was formed on the metallic Ti layer by sputtering. Then, a metallic Ti layer was formed on the Ag-Cu alloy layer by sputtering. Similarly with the first organic layer, an organic layer was formed on the metallic Ti layer. Then, the laminated layers were subjected to heat treatment in a heating furnace in an atmosphere of air at a temperature of 40°C for 300 hours to thermally oxidize the metallic Ti layers into titanium oxide layers. Thus, the light transmitting laminate for optical use according to Example 1 was formed.

### (Examples 2 and 3)

Light transmitting laminates according to Examples 2 and 3 were each formed in the same manner as the light transmitting laminate according to Example 1 except that the organic layers were not formed on the one surface of the OPP film. That is to say, the light transmitting laminates were each formed by laminating a metal oxide layer/a metal layer/and a metal oxide layer in this order to have a multilayer structure.

### (Examples 4 to 10)

Light transmitting laminates according to Examples 4 to 10 were formed in the same manner as the light transmitting laminate according to Example 1 except that a surface protection layer was formed on the other surface of each OPP film. That is to say, in each light transmitting laminate, an organic layer/a metal oxide layer/a metal layer/a metal oxide layer/ and an organic layer were formed on one surface of the OPP film to have a multilayer structure, and a surface protection layer was formed on the other surface of the OPP film. The material of the surface protection layer was as follows:
- Acrylic resin: "UVT clear-TEF046", manufactured by DIC Corporation, UV curable type
- Organic-inorganic hybrid material: TG series of Dainichiseika Color & Chemicals Mfg.Co., Ltd., UV curable type

### (OPP Films)

- 2502: manufactured by Toray Industries, Inc.
- P2108: manufactured by TOYOBO CO., LTD.
- EM-201: manufactured by Oji F-Tex Co., Ltd.

### (Observation of Surface of OPP Film)

The content of silica particles was estimated with respect to arbitrary selected 15 observation areas of 242.3 *µ*m² on the surfaces of each polyolefin layer 12 with the use of a laser microscope "OLYMPUS LEXT OLS 4000", and counting the number of the silica particles in each observation area. The shape of the silica particles was identified as spherical or needle-shaped, and further the maximum particle diameter of the silica particles was obtained. The content of the silica particles 22 was defined by the lowest and highest contents of the silica particles 22 among the contents observed in the 15 observation areas.

The maximum particle diameter was a diameter of the largest particle among the particles observed within a predetermined observation area. The maximum particle diameter was the maximum diameter (long diameter) of a particle.

### (Measurement of Cu Content)

The content of the additive element (Cu) in the Ag-Cu alloy layer was estimated as follows: under each film formation condition, a test specimen was separately prepared by forming an Ag-Cu alloy layer on a glass substrate. The test specimen was immersed in a 6% solution of HNO₃. After elution by ultrasonication for 20 minutes, the Cu content in the test specimen was estimated using the obtained sample solution by an ICP analysis method combined with a preconcentration technique. The Cu content was 4 atom%.

### (Measurement of Thickness of Layers)

The thickness of each layer was measured by observation of the test specimen in a cross section using the field-emission electron microscope (HRTEM) ("JEM2001F", manufactured by JEOL Ltd.)

Each light transmitting laminate was evaluated in layer adhesion, workability, appearance (haze), and heat insulation (thermal transmittance). Further, the light transmitting laminates of Examples 4 to 10 were evaluated also in adhesion of the surface protection layer, and scratch resistance.

### (Adhesion of Layers)

An OHP film having on one surface thereof an organic layer or a metal oxide layer was prepared as a test specimen. An acrylic adhesive sheet having a thickness of 25 µm ("5402", manufactured by Sekisui Chemistry Company, Limited) was attached to the surface of the organic layer or the metal oxide layer, and the sheet was attached on its adhesive face to a surface of a plate glass. A 180-degree peel test (in accordance with JIS A5759, tensile speed of 300 mm/minute) was conducted at the interface between the adhesive face of the plate glass and the organic or metal oxide layer using a table-top type tension testing machine ("AGS-1kNG", manufactured by Minebea) to measure a peeling force, and the measured peeling force was regarded as adhesion between the layers . The tensile load of 8 N/25 mm or larger was regarded as "good" in adhesion, the tensile load of 4 to 7 N/25 mm was regarded as "not good" in adhesion, and the tensile load of 4N/25 mm was evaluated as "bad" in adhesion.

### (Workability)

On a corona-treated OPP film, the layers were continuously formed by continuous sputtering . The shape of a roll of the film was visually observed. When wrinkles or ruffles did not appear, the workability was regarded as "good". When wrinkles or ruffles appeared, the workability was regarded as "bad".

### (Appearance)

The haze of the OPP film was measured in accordance with JIS K7361.

### (Thermal Transmittance)

An acrylic adhesive sheet ("5402", manufactured by Sekisui Chemistry Company, Limited) with a thickness of 25 µm was attached to the surface of the organic thin film or the metal oxide layer of the light transmitting laminate. The adhesive face of the adhesive sheet was attached to one surface of a plate glass. The sample was irradiated with measurement light on the OPP side, and normal emittances of the glass surface and the film surface were evaluated in accordance with JIS R3106. Thermal transmittance was also evaluated (in the unit of W/m²K) in accordance with JIS A5759.

### (Scratch Resistance)

The surface of the surface protection layer of the light transmitting laminate was rubbed with steel wool ("Bon Star No. 0000", manufactured by NIHON STEEL Co., Ltd.) by reciprocating the steel wool on the same surface ten times with a constant load (20g/cm²) applied. When no scratch was visually found on the surface, scratch resistance was regarded as "good". When scratch was visually found on the surface, scratch resistance was regarded as "bad".

### (Adhesion of Surface Protection Layer)

Adhesion of the surface protection layer was evaluated in accordance with JIS K5600-5-6. To be specific, a blade was put on each OPP film with the surface protection layer at a right angle, and six slits were made by the blade at intervals of 2 mm. Further, the direction of the blade was changed by 90°, and other six slits that crosses the already formed six slits at right angles were made by the blade at intervals of 2 mm. Thus, 25 cells were formed on the surface of the film. Then, a tape was attached to the area of the surface of the film in which the cells were formed, and the surface was rubbed over the tape. Finally, the tape was surely torn off at an angle of approximately 60°, and then the number of the cells remaining on the surface of the film was counted by visual observation. When the number of remaining cell is 25, adhesion of the surface protection layer was regarded as "good". When peeling is observed, adhesion of the surface protection layer was evaluated as "bad".

**(Table 1) (Examples 1 to 3 are Reference Examples)**

| | | | | Example | | | Comparative Example | Example | | | | | |
|---|---|---|---|---|---|---|---|---|---|---|---|---|---|
| | | | | 1 | 2 | 3 | 1 | 4 | 5 | 7 | 8 | 9 | 10 |
| OPP film | Type | | | 2502 | P2108 | 2502 | EM-201 | 2502 | 2502 | 2502 | 2502 | 2502 | 2502 |
| | Thickness (µm) | | | 40 | 40 | 40 | 40 | 40 | 40 | 40 | 40 | 40 | 40 |
| | Organic Oxide | | | none | none | none | none | none | none | none | none | none | none |
| | Silica Particles | | | existent | existent | existent | nonexistent | existent | existent | existent | existent | existent | existent |
| | | Shape | | spherical | needle-shape | spherical | - | spherical | spherical | spherical | spherical | spherical | spherical |
| | | Maximum Particle Diameter (µm) | | 6 | 11 | 6 | - | 6 | 6 | 6 | 6 | 6 | 6 |
| | | Content (particles/100 µm²) | min | 16 | 47 | 16 | - | 16 | 16 | 16 | 16 | 16 | 16 |
| | | | max | 35 | 80 | 35 | - | 35 | 35 | 35 | 35 | 35 | 35 |
| Thin Film Layer | Organic Layer (nm) | | | 20 | - | - | 20 | 20 | 20 | 20 | 20 | 20 | 20 |
| | Metal Oxide Layer (nm) | | Ti | 1.6 | 1.6 | 1.6 | 1.6 | 1.6 | 1.6 | 1.6 | 1.6 | 1.6 | 1.6 |
| | Metal Layer (nm) | | Ag-Cu | 10 | 10 | 10 | 10 | 10 | 10 | 10 | 10 | 10 | 10 |
| | Metal Oxide Layer (nm) | | Ti | 1.6 | 1.6 | 1.6 | 1.6 | 1.6 | 1.6 | 1.6 | 1.6 | 1.6 | 1.6 |
| | Organic Layer (nm) | | | 20 | - | - | 20 | 20 | 20 | 20 | 20 | 20 | 20 |
| Surface Protection Layer | | | | - | - | - | - | Acrylic | Organic-norganic hybrid material | | | | |
| | | Silica Content (mass%) | | - | - | - | - | 0 | 2.1 | 2.3 | 3.0 | 4.2 | 5.2 |
| | | Silica Content (kcps) | | - | - | - | - | 0 | 0.98 | 1.07 | 1.39 | 1.96 | 2.44 |
| Layer Adhesion | | | | Good | Good | Good | Not Good | Good | Good | Good | Good | Good | Good |
| Workability | | | | Good | Good | Good | Bad | Good | Good | Good | Good | Good | Good |
| Appearance (Haze %) | | | | 0.8 | 2.2 | 1.0 | 0.6 | 0.8 | 0.8 | 0.8 | 0.8 | 0.8 | 0.8 |
| Adhesion of Surface Protection Layer | | | | - | - | - | Good | Bad | Good | Good | Good | Good | Good |
| Scratch Resistance | | | | - | - | - | Good | Good | Good | Good | Good | Good | Good |
| Thermal Transmittance (W/m²·K) | | | | 4.2 | 4.2 | 4.2 | 4.2 | 4.5 | 4.5 | 4.5 | 4.5 | 4.5 | 4.6 |

Comparative example 1, using an OPP film containing no silica particles on its surface, is inferior in workability and layer adhesion. Meanwhile, Examples, each using an OPP film containing silica particles on its surface, are excellent in workability and layer adhesion. Further, when the silica particles have a spherical shape, deterioration in the haze property is suppressed, and thus the light transmitting laminates are more excellent in appearance.

In examples 4 to 10, scratch resistances are improved due to the surface protection layer. When the surface protection layer is made of an organic-inorganic hybrid material, the surface protection layer is excellent in adhesion. When the silica is contained in the organic-inorganic hybrid material in a less amount, increase of a thermal transmittance is suppressed.

The foregoing description of the preferred embodiments of the present invention has been presented for purposes of illustration and description; however, it is not intended to be exhaustive or to limit the present invention to the precise form disclosed.

## Claims

1. A light-transmitting laminate for optical use (10) comprising:
a polyolefin layer (12);
a thin film layer (14) comprising a metal layer or a metal oxide layer; and
a surface protection layer (16), as an outermost layer, in contact with the polyolefin layer (12) that protects a surface of the polyolefin layer (12),
the metal layer made of at least one selected from silver, a silver alloy, aluminum, an aluminum alloy, iron, and an iron alloy,
the metal oxide layer made of at least one selected from an indium tin oxide, an indium zinc oxide, a zinc oxide, a tin oxide, an aluminum zinc oxide, a gallium zinc oxide, and an indium gallium zinc oxide,
the thin (14) film layer formed by sputtering,
the surface protection layer (16) comprising an organic-inorganic hybrid material, and
the polyolefin layer (12) comprising on both surfaces thereof silica particles (22),
wherein the silica particles (22) have a maximum particle diameter within a range of 6 to 11 µm, and
wherein the polyolefin layer (12) comprises the silica particles (22) on the surface thereof at a content of 10 to 40 particles/100 *µ*m².

2. The light-transmitting laminate for optical use (10) according to claim 1, wherein the metal layer is made of silver or the silver alloy.

3. The light-transmitting laminate for optical use (10) according to claims 1 or 2, wherein the polyolefin layer (12) comprises a biaxially oriented polypropylene film.

4. The light-transmitting laminate for optical use (10) according to any one of claims 1 to 3, wherein the silica particles (22) are spherical particles.

5. The light-transmitting laminate for optical use (10) according to any one of claims 1 to 4, wherein the organic-inorganic hybrid material comprises 2.1 to 5.2 mass% of a metal ingredient.

6. The light-transmitting laminate for optical use (10) according to any one of claims 1 to 5 wherein the polyolefin layer (12) has a haze of 3.0% or less.

7. The light-transmitting laminate for optical use (10) according to any one of claims 1 to 6, wherein the thin film layer (14) comprises the metal layer, and further comprises an organic thin film that has a higher refractive index than the metal layer.

8. The light-transmitting laminate for optical use (10) according to claim 7, wherein the organic thin film is made of a polymer having a triazine ring.

## Patentansprüche

1. Lichtdurchlässiges Laminat für die optische Verwendung (10), umfassend:
eine Polyolefinschicht (12);
eine Dünnfilmschicht (14), die eine Metallschicht oder eine Metalloxidschicht umfasst; und
eine Oberflächenschutzschicht (16) als äußerste Schicht in Kontakt mit der Polyolefinschicht (12), die eine Oberfläche der Polyolefinschicht (12) schützt,
wobei die Metallschicht aus mindestens einem, ausgewählt aus Silber, einer Silberlegierung, Aluminium, einer Aluminiumlegierung, Eisen und einer Eisenlegierung, hergestellt ist,
die Metalloxidschicht aus mindestens einem, ausgewählt aus einem Indiumzinnoxid, einem Indiumzinkoxid, einem Zinkoxid, einem Zinnoxid, einem Aluminiumzinkoxid, einem Galliumzinkoxid und einem Indiumgalliumzinkoxid, hergestellt ist,
die Dünnfilmschicht (14) durch Sputtern gebildet ist,
die Oberflächenschutzschicht (16) ein organisch-anorganisches Hybridmaterial umfasst und
die Polyolefinschicht (12) auf beiden Oberflächen davon Siliziumdioxidteilchen (22) umfasst,
wobei die Siliziumdioxidteilchen (22) einen maximalen Teilchendurchmesser in einem Bereich von 6 bis 11 µm aufweisen, und
wobei die Polyolefinschicht (12) die Siliziumdioxidteilchen (22) auf ihrer Oberfläche in einem Gehalt von 10 bis 40 Teilchen/100 *µ*m² umfasst.

2. Lichtdurchlässiges Laminat für die optische Verwendung (10) nach Anspruch 1, wobei die Metallschicht aus Silber oder der Silberlegierung hergestellt ist.

3. Lichtdurchlässiges Laminat zur optischen Verwendung (10) nach Anspruch 1 oder 2, wobei die Polyolefinschicht (12) einen biaxial orientierten Polypropylenfilm umfasst.

4. Lichtdurchlässiges Laminat für die optische Verwendung (10) nach einem der Ansprüche 1 bis 3, wobei die Siliziumdioxidteilchen (22) sphärische Teilchen sind.

5. Lichtdurchlässiges Laminat für die optische Verwendung (10) nach einem der Ansprüche 1 bis 4, wobei das organisch-anorganische Hybridmaterial 2,1 bis 5,2 Massen-% eines Metallinhaltsstoffs umfasst.

6. Lichtdurchlässiges Laminat für die optische Verwendung (10) nach einem der Ansprüche 1 bis 5, wobei die Polyolefinschicht (12) eine Haze von 3,0% oder weniger aufweist.

7. Lichtdurchlässiges Laminat für die optische Verwendung (10) nach einem der Ansprüche 1 bis 6, wobei die Dünnfilmschicht (14) die Metallschicht umfasst, und weiter einen organischen Dünnfilm umfasst, der einen höheren Brechungsindex als die Metallschicht aufweist.

8. Lichtdurchlässiges Laminat für die optische Verwendung (10) nach Anspruch 7, wobei der organische Dünnfilm aus einem Polymer mit einem Triazinring hergestellt ist.

## Revendications

1. Stratifié transmettant la lumière pour utilisation optique (10) comprenant:
une couche de polyoléfine (12);
une couche à film mince (14) comprenant une couche de métal ou une couche d'oxyde de métal, et
une couche de protection surfacique (16), comme couche la plus extérieure, en contact avec la couche de polyoléfine (12) qui protège une surface de la couche de polyoléfine (12),
la couche de métal fabriquée d'au moins l'un sélectionné parmi l'argent, un alliage d'argent, l'aluminium, un alliage d'aluminium, le fer et un alliage de fer,
la couche d'oxyde de métal fabriquée d'au moins l'un sélectionné parmi un oxyde d'indium et d'étain, un oxyde d'indium et de zinc, un oxyde de zinc, un oxyde d'étain,
un oxyde d'aluminium et de zinc, un oxyde de gallium et de zinc et un oxyde d'indium de gallium et de zinc,
la couche à film mince (14) fabriquée par pulvérisation,
la couche de protection surfacique (16) comprenant une matière hybride organique-inorganique, et
la couche de polyoléfine (12) comprenant sur les deux surfaces de celle-ci des particules de silice (22),
dans laquelle les particules de silice (22) ont un diamètre particulaire maximum compris dans l'intervalle entre 6 et 11 µm, et
dans laquelle la couche de polyoléfine (12) comprend les particules de silice (22) à la surface de celle-ci en une quantité de 10 à 40 particules/100 µm².

2. Stratifié transmettant la lumière pour utilisation optique (10) selon la revendication 1, dans lequel la couche de métal est fabriquée en argent ou en un alliage d'argent.

3. Stratifié transmettant la lumière pour utilisation optique (10) selon les revendications 1 ou 2, dans lequel la couche de polyoléfine (12) comprend un film de polypropylène à orientation biaxiale.

4. Stratifié transmettant la lumière pour utilisation optique (10) selon l'une quelconque des revendications 1 à 3, dans lequel les particules de silice (22) sont des particules sphériques.

5. Stratifié transmettant la lumière pour utilisation optique (10) selon l'une quelconque des revendications 1 à 4, dans lequel la matière hybride organique-inorganique comprend de 2,1 à 5,2% en masse d'un ingrédient métallique.

6. Stratifié transmettant la lumière pour utilisation optique (10) selon l'une quelconque des revendications 1 à 5, dans lequel la couche de polyoléfine présente un voile de 3,0% ou moins.

7. Stratifié transmettant la lumière pour utilisation optique (10) selon l'une quelconque des revendications 1 à 6, dans lequel la couche à film mince (14) comprend la couche de métal, et comprend en outre un film mince organique présentant un indice de réfraction plus élevé que la couche de métal.

8. Stratifié transmettant la lumière pour utilisation optique (10) selon la revendication 7, dans lequel le film mince organique est fabriqué d'un polymère avec un cycle triazine.
